# EUROPÄISCHE PATENTSCHRIFT

(11) **EP 1 134 849 B1**
(45) Veröffentlichungstag und Bekanntmachung des Hinweises auf die Patenterteilung: **02.05.2003**
(21) Anmeldenummer: 01103724.9
(22) Anmeldetag: 15.02.2001
(51) Int. Cl.: H01R 13/514, H01R 9/28, H01R 9/24, H01R 13/41, H05B 33/02, G09F 9/30, H01L 33/00, G09F 9/33

(54) **Illuminationsbausatz für Beleuchtungs-, Anzeige- oder Hinweiszwecke sowie elektrischer Steckverbinder für einen solchen Illuminationsbausatz**
Illumination set for use in illuminating, displaying or indicating and an electrical plug connector for such a set
Jeu de pièces d'éclairage pour l'éclairage, l'affichage ou la signalisation et connecteur électrique pour un tel jeu de pièces

(30) Priorität: 16.03.2000 DE 10012734
(43) Veröffentlichungstag der Anmeldung: 19.09.2001
(73) Patentinhaber: BJB GmbH & Co. KG, 59755 Arnsberg (DE)
(72) Erfinder: Henrici, Dieter, Dipl.-Ing., 59757 Arnsberg (DE); Wedding, Hans, 59759 Arnsberg (DE)
(74) Vertreter: Patentanwälte Ostriga & Sonnet

(56) Entgegenhaltungen:
- US-A- 4 445 132
- US-A- 4 843 280
- PATENT ABSTRACTS OF JAPAN vol. 1995, no. 08, 29. September 1995 (1995-09-29) & JP 07 115228 A (STANLEY ELECTRIC CO LTD), 2. Mai 1995 (1995-05-02)

## Beschreibung

Die Erfindung betrifft zunächst einen Illuminationsbausatz für Beleuchtungs-, Anzeige- oder Hinweiszwecke, umfassend wenigstens zwei identische, Licht spendende Module mit je wenigstens einer LED und den zu ihrer Ansteuerung erforderlichen elektronischen Bauelementen wie Leiterbahnen, Widerständen od.dgl. und mit je einem randnah am Modul angeordneten Kontaktzonensatz mit wenigstens zwei Kontaktzonen unterschiedlichen Potentials zum Anschluß bzw. Abgriff der Spannung nach dem Oberbegriff des Anspruchs 1. Ferner bezieht sich die Erfindung auf einen Steckverbinder für einen Illuminationsbausatz nach dem Oberbegriff des Anspruchs 5.

Lichtemissionsdioden (LED) werden in jüngster Zeit verstärkt für die unterschiedlichsten Illuminationszwecke verwendet. Der Vorteil der LED besteht insbesondere in ihrem geringen Energiebedarf, geringer Wäremeabgabe, der hohen Leuchtdichte und einer gegenüber herkömmlichen Lampen wesentlich höheren Lebensdauer. Mehrfachanordnungen von LED werden für Beleuchtungszwecke ebenso eingesetzt wie vor allem für Anzeige- und Hinweiszwecke. In verstärktem Maße werden Rückleuchten, Bremsleuchten und Blinkleuchten an Fahrzeugen derart ausgerüstet. Auch Werbe- und Hinweisschilder lassen sich mit solchen LED hervorragend gestalten.

Es ist bekannt, eine Vielzahl von identischen Modulen mit beispielsweise vier auf je einer Leiterplatte montierten LED zu einer Baugruppe zusammenzufassen. Eine solche Baugruppe umfaßt dann z.B. 4 x 6 solcher Module mit einheitlichen Rastermaßen. Eine solche Anordnung ist elektrisch derart verschaltet, dass sämtliche LED aller Module gleichzeitig zum Leuchten gebracht werden können. Man kann aber auch eine beliebige Anzahl von zusammenhängenden Modulen aus der Baugruppe herausbrechen, um diesen Teil, z.B. einer Reihe von 2 x 3 Modulen, zu Illuminationszwecken zu verwenden. Der Rest der Baugruppe bleibt weiterhin funktionsfähig.

Die Module, die aus elektronischen Schaltungen mit Leiterbahnen, je wenigstens einer LED und den notwendigen Vorschaltwiderständen bestehen, sind im Prinzip flache Platinen, wobei die elektronischen Bauelemente Widerstände und LED als SMD-Bauteile im SMT-Verfahren montiert sind (SMD = Surface Mounted Devices; SMT = Surface Mount Technologie).

Aufgabe der Erfindung ist es zunächst, einen Illuminationsbausatz der im Oberbegriff des Anspruches 1 als bekannt vorausgesetzten Art so auszugestalten und weiterzubilden, dass eine nahezu beliebige Anordnung je wenigstens zweier Module in dem vorgegebenen Rastermaß insbesondere in der Höhe platzsparend aufbauen zu können. Eine weitere Aufgabe der Erfindung besteht darin, einen zuverlässigen und kleinbauenden Steckverbinder dazu vorzuschlagen.

Die Erfindung löst die erste Aufgabe mit den Merkmalen des unabhängigen Anspruches 1 und dem entsprechend dadurch gekennzeichnet, dass die Kontaktzonen jedes Kontaktzonensatzes längs einer Linie angeordnet sind, die im wesentlichen lotrecht zur benachbarten Randkante des Moduls ausgerichtet ist und dass zur mechanischen und elektrischen Verbindung zweier Module miteinander ein auf den Rand jedes Moduls aufsteckbarer Steckverbinder vorgesehen ist mit Kontakten, die sämtlich in einer Reihe angeordnet sind, wobei die jeweils gleichen Abstand von der Quermittelebene des Steckverbinders aufweisenden Kontakte gebrückt sind.

Das Wesen der Erfindung besteht also im Prinzip darin, die Kontaktzonen jedes Kontaktzonensatzes jedes Moduls in geschickter Weise so anzuordnen, dass jeweils zwei Module mit einem sehr einfach gestalteten Steckverbinder, dessen Kontakte sich nicht überkreuzen müssen, elektrisch und mechanisch miteinander verbunden werden können. Dass die Kontakte des Steckverbinders sämtlich in einer Reihe angeordnet sind, bedeutet auch, dass die Kontakte die jeweiligen Module nur von einer Seite her kontaktieren, woraus sich eine extrem flache Bauweise des Steckverbinders ergibt.

In weiterer Ausgestaltung der Erfindung ist vorgesehen, dass die Kontaktzonen durch die Leiterplatte des Moduls durchkontaktiert sind, so dass die Kontakte des Steckverbinders die Kontaktzonen wahlweise von der einen oder der anderen Seite des Moduls kontaktieren können. Dadurch ist es auf einfache Weise z.B. möglich, mittels des Steckverbinders zwei mit ihm zu verbindende Module mit verschiedener Abstrahlrichtung ihrer LED verpolungssicher anzuordnen.

Vorzugsweise ist des weiteren jedem Kontaktzonensatz des Moduls eine Ausnehmung zugeordnet zum vorzugsweise wiederlösbaren Eingriff eines Riegelzapfens des Steckverbinders, wobei es in diesem Zusammenhang vorteilhaft ist, wenn die Ausnehmung in derselben Reihe angeordnet ist wie die Kontaktzone des Moduls und der Riegelzapfen in derselben Reihe wie die Kontakte des Steckverbinders.

Des weiteren betrifft die Erfindung einen Steckverbinder eines Illuminationsbausatzes, der entsprechend dem-abhängigen Anspruch 5 dadurch gekennzeichnet ist, dass er einen Kontaktträger sowie einen Kontaktsatz umfasst, dessen Kontaktelemente auf einer Seite des Kontaktträgers an diesem befestigt sind.

Bevorzugt sind die Kontaktelemente flach ausgebildet und erstrecken sich im wesentlichen parallel zur Hauptebene des plattenhaft flachen Kontaktträgers.

Jedes Kontaktelement bildet vorzugsweise eine Kontaktbrücke zur Verbindung der Kontaktzonen desselben Potentials zweier Module aus. In diesem Zusammenhang ist es vorteilhaft, wenn jedes Kontaktelement einen Befestigungsabschnitt und daran angebunden einen Kontaktabschnitt ausbildet, der jeweils im wesentlichen gabelförmig ausgebildet ist und die Gabelschenkel des einen Kontaktelementes zwischen den Gabelschenkeln eines anderen Kontaktelements in derselben Ebene angeordnet sind.

In weiterer Ausgestaltung der Erfindung könnten die Kontaktelemente ausgeklinkte Ankerkanten aufweisen, mit denen sie formund/oder klemmschlüssig an Rastzapfen des Kontaktträgers angesteckt sind.

Zur Verriegelung des Steckverbinders am Modul ist vorgesehen, dass am Kontaktträger freigeschnittene Federzungen ausgebildet sind, an deren Enden die zum Eingriff in die Ausnehmungen der Module bestimmten Riegelzapfen angeordnet sind.

Sofern nicht aufgrund der baulichen Gegebenheiten bereits Maßnahmen getroffen sind, die den bislang beschriebenen Steckverbinder so gegen die Kontaktzonen eines Moduls pressen, dass hinreichend große Kontaktkräfte aufgebaut werden können, ist vorgesehen, dass der Steckverbinder zusätzlich einen insbesondere plattenartigen Deckel umfasst, der zwischen sich und den Kontakten des Kontaktträgers einander gegenüberliegende Schlitzaufnahmen für Randkanten zweier zu verbindender Module ausbildet. Vorzugsweise sind Kontaktträger und Deckel miteinander - ggf. wiederlösbar - verrastbar.

Mit der Erfindung gelingt es, im vorgegebenen Raster der verwendeten Module Illuminationsbausätze aufzubauen, die eine große Vielzahl von Formen aufweisen können. So lassen sich auf einfache Weise linienhafte oder flächenhafte Beleuchtungseinrichtungen bauen wie auch solche mit bestimmten Formen, wie beispielsweise Buchstaben, Zahlen od.dgl., z.B. im Raster eine sog. 7-Segment-Anzeige. Technische Grenzen bezüglich der Anzahl von verbindbaren Modulen ergeben sich lediglich aus den maximal zulässigen Stromstärken für das System und eventuellen Spannungsverlusten in sehr langen Verzweigungen.

Im übrigen versteht sich die Erfindung am besten anhand der nachfolgenden Beschreibung eines in den Zeichnungen dargestellten bevorzugten Ausführungsbeispiels. In den Zeichnungen zeigen:
- Fig. 1: eine Mehrfachanordnung von mechanisch und elektrisch zusammenhängenden identischen Modulen,
- Fig. 2: eines der Module in schematischer schaubildlicher Darstellung,
- Fig. 3: einen Steckverbinder mit zwei Kontaktelementen in perspektivischer Explosionsdarstellung mit Blickrichtung auf seinen Deckel,

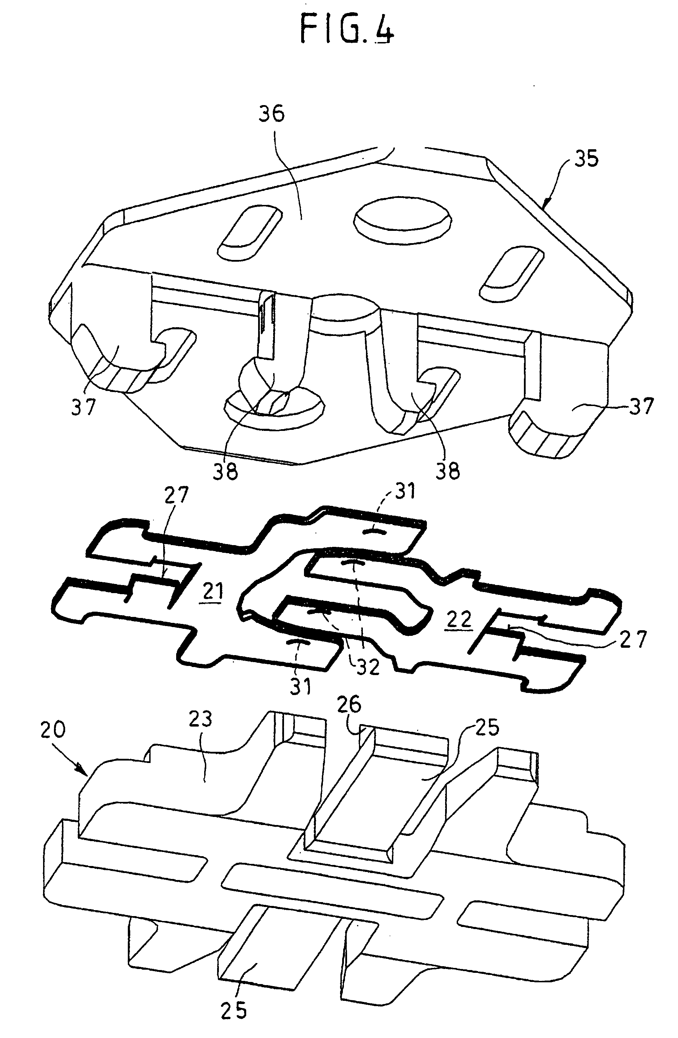

- Fig. 4: eine entsprechende Darstellung, jedoch mit Blickrichtung unter den Deckel,
- Fig. 5: einen aus Basisplatte und Kontaktelementen bestehenden Steckverbinder ohne Deckel in schaubildlicher Darstellung,
- Fig. 6: eine schaubildliche Darstellung des Verbindungsbereichs zweier Module mittels eines Steckverbinders, und
- Fig. 7: eine schematische Darstellung der Zuordnung der Steckverbinder-Kontaktelemente aus Fig. 6 zu den Modulen.

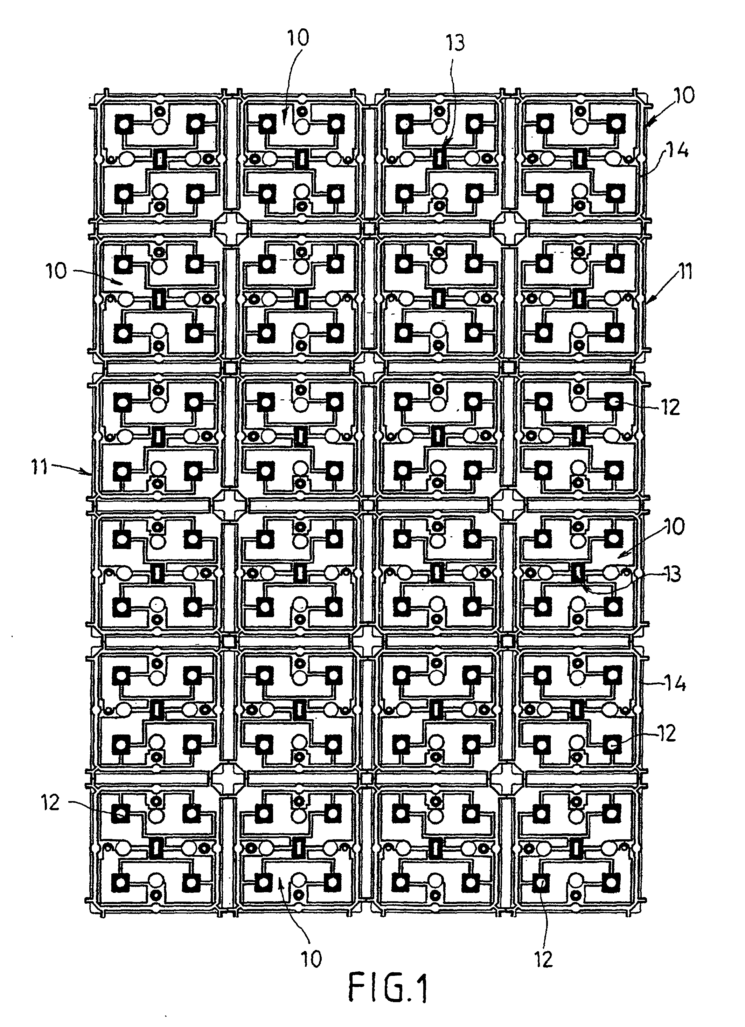

Fig. 1 zeigt eine Mehrfachanordnung von untereinander identischen Modulen 10. Jedes dieser Module 10 umfasst eine Leiterplatte 11, vier LED 12 sowie Widerstände 13 und Leiterbahnen 14. Die Beschaltung ist so ausgelegt, dass sämtliche Platinen 11 über Leiterbahnen elektrisch miteinander verbunden sind. Die beim Ausführungsbeispiel nach Fig. 1 insgesamt 96 LED der 24 Module 10 könnten daher bei Spannungsbeaufschlagung gleichzeitig zum Leuchten gebracht werden.

Es ist aber auch möglich, eines oder mehrere der Module 10 aus dem in Fig. 1 dargestellten Gesamtverband herauszubrechen. Sowohl die herausgebrochenen Module 10 als auch die im Verband verbleibenden Module 10 lassen sich wieder elektrisch betreiben.

So ist es beispielsweise möglich, aus dem Gesamtverband der Fig. 1 so viele Module herauszubrechen, dass sich ein Buchstabe, z.B. der Buchstabe E ergibt. Zum anderen ist es möglich, eine Reihe oder eine Spalte abzutrennen und diese mit einer anderen Reihe oder Spalte oder einzelnen Modulen 10 miteinander zu verbinden. Dazu dient, wie weiter unten beschrieben wird, der erfindungsgemäße Steckverbinder.

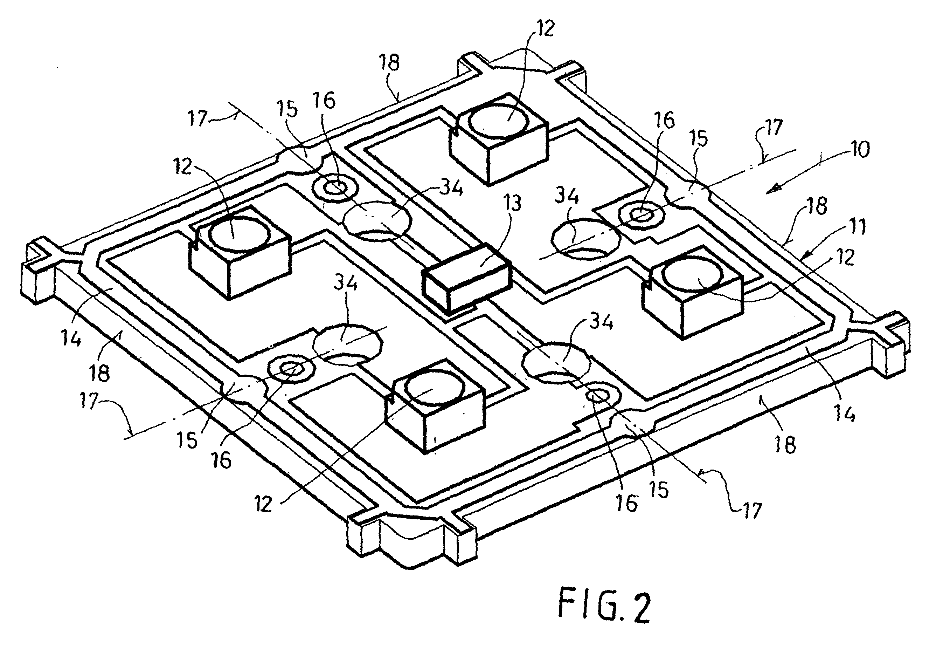

Fig. 2 zeigt ein Modul in gegenüber Fig. 1 vergrößerter Wiedergabe. Insbesondere lässt sich erkennen, dass die mit 15 und 16 bezeichneten Kontaktzonen, die jeweils einen Pluspol (Kontaktzone 15) und einen Minuspol (Kontaktzone 16) bilden, auf einer Linie 17 angeordnet sind, die zur zugehörigen Randkante 18 des Moduls 10 zumindest im wesentlichen senkrecht steht. Beide Kontaktzonen 15 und 16, die zusammen einen Kontaktzonensatz bilden, sind randnah angeordnet. Beim Ausführungsbeispiel ist jeweils der Pluspol 15 außen und der Minuspol 16 weiter innen liegend auf der Linie 17 angeordnet.

Das Ausführungsbeispiel zeigt ein Modul 10 quadratischen Umrisses mit vier SMD-LED 12. Andere Formen sind selbstverständlich auch möglich, z.B. würde man bei einem Modul-Umriss in Form eines regelmäßigen Sechsecks ein Wabenmuster erhalten, welches sich besonders für eine Anordnung von drei oder sechs LED eignen würde.

Wesentlich ist, dass für jede einzelne LED oder für jede LED-Verschaltung einheitlich gestaltete Kontaktzonensätze 15/16 vorgesehen sind und dass diese bezüglich der zugeordneten Randkante alle in derselben Art und Weise angeordnet sind. Dies ist eine Voraussetzung für einen sehr einfach ausgebildeten Steckverbinder, mit dem jeweils zwei Module 10 elektrisch und mechanisch miteinander verbunden werden können. Vorteilhafterweise ist an jeder Randkante des Moduls 10 ein Kontaktzonensatz vorhanden, damit jede beliebige Randkante eines Moduls mit jeder beliebigen Randkante eines anderen Moduls verbunden werden kann.

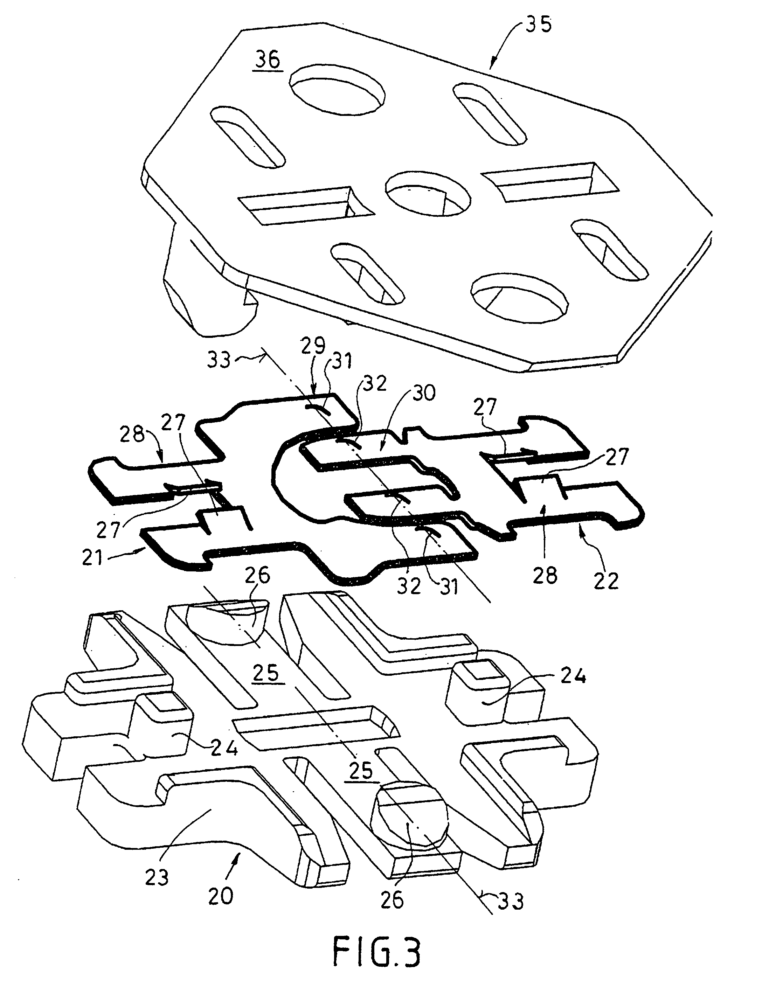

Einen solchen Steckverbinder zeigt Fig. 3 in vergrößertem Maßstab. Der umfasst zumindest einen Kontaktträger 20 aus Isolierstoff und zwei Kontaktelemente 21 und 22. Der Kontaktträger 20 besteht aus einem Kunststoffspritzgießteil und weist im wesentlichen eine Basisplatte 23 auf sowie zwei Rastnocken 24 und zwei Federzungen 25 mit Riegelzapfen 26.

Die Rastzapfen 24 dienen zur festen Verankerung der beiden Kontaktelemente 21 und 22 am Kontaktträger 20, die zu diesem Zweck mit Ankerkanten 27 versehen sind, welche aus dem Blechmaterial der Kontaktelemente 21 und 22 ausgeklinkt und ausgestellt sind. Wenn die Kontaktelemente 21 und 22 auf die Basisplatte 23 des Kontaktträgers 20 aufgepresst werden, sind sie sicher an diesem befestigt.

Wie aus Fig. 3 weiterhin ersichtlich ist, weisen die Kontaktelemente 21 und 22 außer ihrem die Ankerkanten 27 beinhaltenden Befestigungsabschnitt 28 jeweils noch einen gabelförmigen Kontaktabschnitt 29 bzw. 30 auf.

Die Kontakte 31 des Kontaktelements 21 und die Kontakte 32 des Kontaktelementes 22, die aus kleinen, warzenartigen Ausprägungen bestehen, liegen sämtlich auf einer mit 33 bezeichneten Linie. Auf derselben Linie bei montiertem Steckverbinder 19 sind auch die Riegelzapfen 26 angeordnet. Sie dienen zum formschlüssigen Eingriff in Durchbrüche 34 der Platine 11 jedes Moduls 10 (Fig. 2).

Ein lediglich aus einem Kontaktträger 20 und den beiden Kontaktelementen 21 und 22 bestehender Steckverbinder kann durch Druckkontaktierung zwei Module elektrisch leitend und mechanisch fest miteinander verbinden, sofern z.B. geräteseitig dafür gesorgt ist, dass dieser Steckverbinder fest auf die Oberflächen der Module 10 aufgepresst und festgehalten wird.

Für eine "freie" Steckverbindung ist jedoch des weiteren der in Fig. 3 dargestellte Deckel 35 vorgesehen. Dieser umfasst eine flache Deckelplatte 36, die an ihrer Unterseite mit zwei Paaren von Rasthaken 37 und 38 versehen ist, mit denen sie fest, d.h. unter Erzeugung eines hinreichenden Kontaktdrucks, am Kontaktträger 20 verankerbar ist.

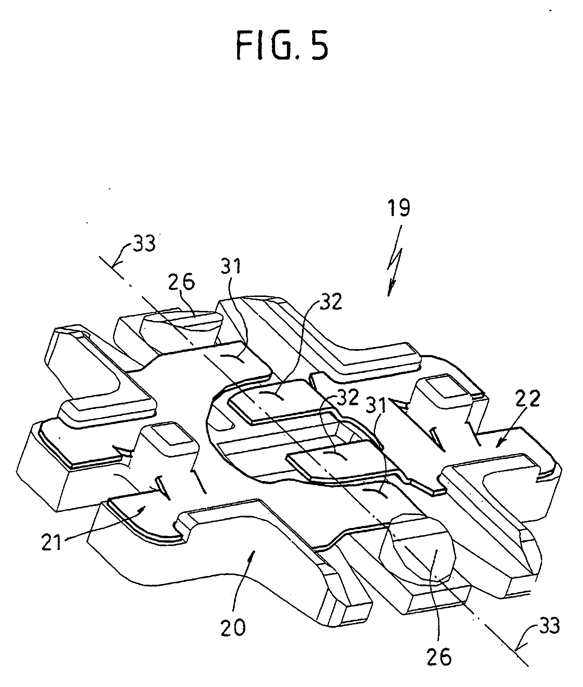

Fig. 5 zeigt einen Steckverbinder 19 in der einfachen Ausführung ohne Deckel 35. Hier erkennt man die Verriegelung der extrem flachen Kontaktelemente 21 und 22 am Kontaktträger 20 und man sieht, dass die Kontakte 31 und 32 mit den Riegelzapfen 26 sämtlich in einer Reihe 33 angeordnet sind.

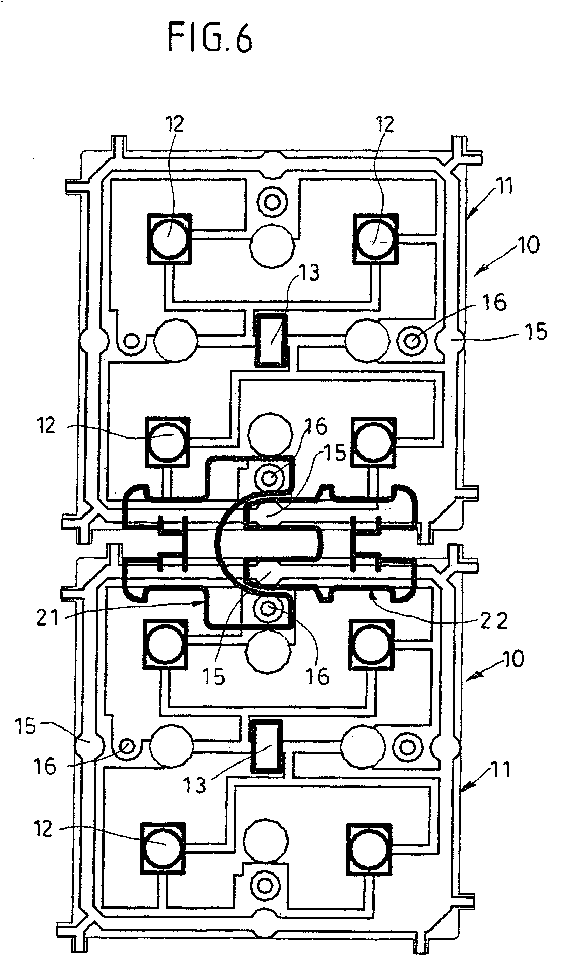

Sofern auf den Steckverbinder nach Fig. 5 der zuvor beschriebene Deckel aufgerastet worden ist, bildet dieser zwischen sich und dem Kontaktträger 20 bzw. den Kontakten 31 und 32 in gegenüberliegender Anordnung jeweils einen randoffenen Einführungsschlitz für die Randkante eines Moduls 10 aus. Zwei durch einen solchen Steckverbinder 19 miteinander verbundenen Module 10 veranschaulicht Fig. 6, wobei allerdings vom Verbinder nur die Kontaktelemente 21 und 22 dargestellt sind. Man erkennt, dass jedes Kontaktelement 21 eine elektrische Brücke darstellt. Das Kontaktelement 21 verbindet die beiden Kontaktflächen 16 der Module 10 und das Kontaktelement 22 brückt die Kontaktflächen 15 des anderen Potentials.

Bis jetzt wurde davon ausgegangen, dass die Kontaktelemente 21 und 22 des Steckverbinders 19 auf der Oberseite des jeweiligen Moduls 10, auf der die SMD-Bauelemente 12 und 13 montiert sind, kontaktiert. Für den Fall, dass die Kontaktzonen 15 und 16 (und zwar beide) durch die Platine 11 der Module 10 durchkontaktiert sind, können die Module oder kann eines der Module auch mit in entgegengesetzter Richtung weisenden LED mit dem Steckverbinder 19 verbunden werden. In diesem Falle kontaktieren die Kontaktelemente 21 und 22 dann wahlweise Kontaktzonensätze 15/16 auf der Oberseite oder der Unterseite eines Moduls 10 bei stets richtiger Polung.

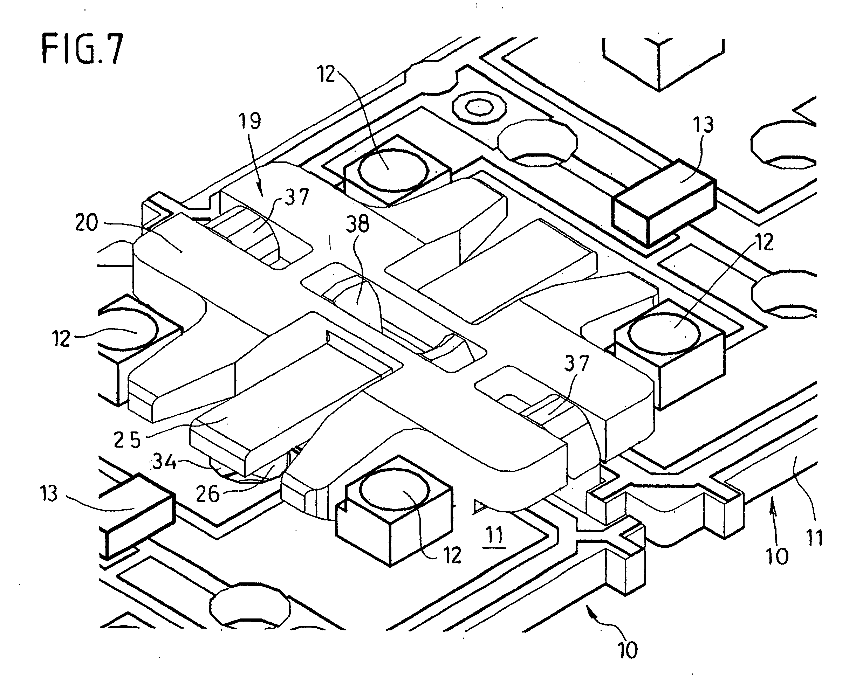

Fig. 7 zeigt zwei Module 10 in schaubildlicher Darstellung mit Blick auf deren Bestückungsseite und einen die beiden Module 10 kuppelnden Steckverbinder 19. In dieser Ansicht verdeckt der Kontaktträger 20 des Steckverbinders 19 die Kontaktelemente. Gut zu erkennen ist aus dieser Darstellung die extrem flache Bauweise des Steckverbinders 19, dessen Kontaktträger einschließlich der an ihm angebrachten Flachkontakte im wesentlichen nur so dick ist wie eine SMD-LED 12 auf der Platine 11 aufbaut.

## Patentansprüche

1. Illuminationsbausatz für Beleuchtungs-, Anzeige- oder Hinweiszwecke, umfassend wenigstens zwei identische, Licht spendende Module (10) mit je wenigstens einer LED (12) und den zu ihrer Ansteuerung erforderlichen elektronischen Bauelementen wie Leiterbahnen (14), Widerständen (13) od.dgl. und mit je einem randnah am Modul (10) angeordneten Kontaktzonensatz (15/16) mit wenigstens zwei Kontaktzonen unterschiedlichen Potentials zum Anschluß bzw. Abgriff der Spannung, **dadurch gekennzeichnet, dass** die Kontaktzonen (15, 16) jedes Kontaktzonensatzes (15/16) längs einer Linie (17) angeordnet sind, die lotrecht zur benachbarten Randkante des Moduls (10) ausgerichtet ist und dass zur mechanischen und elektrischen Verbindung zweier Module (10) miteinander ein auf den Rand jedes Moduls (10) aufsteckbarer Steckverbinder (19) vorgesehen ist mit Kontakten (31, 32), die sämtlich in einer Reihe (33) angeordnet sind, wobei die jeweils gleichen Abstand von der Quermittelebene des Steckverbinders (19) aufweisenden Kontakte (31; 32) gebrückt sind.

2. Illuminationsbausatz nach Anspruch 1, **dadurch gekennzeichnet, dass** die Kontaktzonen (15, 16) durch die Leiterplatte (11) des Moduls (10) durchkontaktiert sind, so dass die Kontakte (31, 32) des Steckverbinders (19) die Kontaktzonen (15; 16) wahlweise von der einen oder der anderen Seite des Moduls (10) kontaktieren können.

3. Illuminationsbausatz nach Anspruch 1, **dadurch gekennzeichnet, dass** jedem Kontaktzonensatz (15/16) des Moduls (10) eine Ausnehmung (34) zugeordnet ist zum, vorzugsweise wiederlösbaren, Eingriff eines Riegelzapfens (26) des Steckverbinders (19).

4. Illuminationsbausatz nach Anspruch 3, **dadurch gekennzeichnet, dass** die Ausnehmung (34) in derselben Reihe (17) angeordnet wie die Kontaktzonen (15, 16) des Moduls (10) und der Riegelzapfen (26) in derselben Reihe (33) wie die Kontakte (31, 32) des Steckverbinders (19).

5. Illuminationsbausatz nach einem der Ansprüche 1 bis 4, **dadurch gekennzeichnet, dass** der Steckverbinder (19) einen Kontaktträger (20) sowie einen Kontaktsatz (31/32) umfasst, dessen Kontaktelemente (21, 22) auf einer Seite des Kontaktträgers (20) an diesem befestigt sind.

6. Illuminationsbausatz nach Anspruch 5, **dadurch gekennzeichnet, dass** die Kontaktelemente (21, 22) flach ausgebildet sind und sich im wesentlichen parallel zur Hauptebene des plattenhaft flachen Kontaktträgers (20) erstrecken.

7. Illuminationsbausatz nach Anspruch 5 oder 6, **dadurch gekennzeichnet, dass** jedes Kontaktelement (21, 22) eine Kontaktbrücke zur Verbindung der Kontaktzonen (15; 16) desselben Potentials zweier Module (20) ausbildet.

8. Illuminationsbausatz nach Anspruch 7, **dadurch gekennzeichnet, dass** jedes Kontaktelement (21, 22) einen Befestigungsabschnitt (28) und daran angebunden einen Kontaktabschnitt (29; 30) ausbildet, der jeweils im wesentlichen gabelförmig ausgebildet ist und dass die Gabelschenkel des einen Kontaktelements (22) zwischen den Gabelschenkeln eines anderen Kontaktelements (21) in derselben Ebene angeordnet sind.

9. Illuminationsbausatz nach einem der Anspruch 5 bis 7, **dadurch gekennzeichnet, dass** die Kontaktelemente (21, 22) ausgeklinkte Ankerkanten (27) aufweisen, mit denen sie form- und/oder klemmschlüssig an Rastzapfen (24) des Kontaktträgers (20) angesteckt sind.

10. Illuminationsbausatz nach Anspruch 2 sowie einem der Ansprüche 5 bis 9, **dadurch gekennzeichnet, dass** am Kontaktträger (20) freigeschnittene Federzungen (25) ausgebildet sind, an deren Enden die zum Eingriff in die Ausnehmungen (34) der Module (20) bestimmten Riegelzapfen (26) angeordnet sind.

11. Illuminationsbausatz nach einem der Ansprüche 5 bis 7, **dadurch gekennzeichnet, dass** er zusätzlich einen insbesondere plattenartigen Deckel (35) umfaßt, der zwischen sich und den Kontakten (31, 32) des Kontaktträgers (20) einander gegenüberliegende Schlitzaufnahmen für Randkanten zweier zu verbindender Module (20) ausbildet.

12. Illuminationsbausatz nach Anspruch 11, **dadurch gekennzeichnet, dass** Kontaktträger (20) und Deckel (35) miteinander verrastbar sind.

## Claims

1. Illumination set for lighting, display or information purposes, comprising at least two identical, light-dispensing modules (10) each comprising at least one LED (12) and the electronic components necessary for their control such as conducting paths (14), resistors (13) or the like, and each having a contact zone set (15/16) arranged in the vicinity of the edge on the module (10), with at least two contact zones of different potential for voltage connection or tapping, **characterised in that** the contact zones (15,16) of each contact zone set (15/16) are arranged along a line (17) that is aligned perpendicular to the adjacent boundary edge of the module (10) and that a connector (19) that can be slipped onto the edge of each module (10) is provided for the mechanical and electrical connection of two modules (10) to one another and has contacts (31, 32) that are all arranged in a row (33), wherein the contacts (31; 32) are in each case bridged having the same distance from the transverse mid-plane of the connector (19).

2. Illumination kit according to claim 1, **characterised in that** the contact zones (15, 16) are plated-through via the printed circuit board (11) of the module (10) so that the contacts (31, 32) of the connector (19) can contact the contact zones (15; 16) as desired from one or other side of the module (10).

3. Illumination kit according to claim 1, **characterised in that** a recess (34) is associated with each contact zone set (15/16) of the module (10) for the preferably releasable engagement of a locking stud (26) of the connector (19).

4. Illumination kit according to claim 3, **characterised in that** the recess (34) is arranged in the same row (17) as the contact zones (15, 16) of the module (10) and the locking stud (26) is arranged in the same row (33) as the contacts (31, 32) of the connector (19).

5. Illumination kit according to one of claims 1 to 4, **characterised in that** the connector (19) comprises a contact carrier (20) as well as a contact set (31/32), whose contact elements (21, 22) are secured on one side of the contact carrier (20) to the latter.

6. Illumination kit according to claim 5, **characterised in that** the contact elements (21, 22) are formed flat and extend substantially parallel to the principal plane of the flat contact carrier (20) formed as a plate.

7. Illumination kit according to claim 5 or 6, **characterised in that** each contact element (21, 22) forms a contact bridge for connecting the contact zones (15; 16) of the same potential of two modules (20).

8. Illumination kit according to claim 7, **characterised in that** each contact element (21, 22) forms a securement section (28) and a contact section (29; 30) joined thereto and that in each case is substantially fork-shaped, and that the fork legs of one contact element (22) are arranged between the fork legs of another contact element (21) in the same plane.

9. Illumination kit according to one of claims 5 to 7, **characterised in that** the contact elements (21, 22) have coped anchoring edges (27) by means of which they can engage in an interlocking and/or clamping manner with catch studs (24) of the contact carrier (20).

10. Illumination kit according to claim 2 as well as one of claims 5 to 9, **characterised in that** free cut-out spring tongues (25) are formed on the contact carrier (20), on the ends of which tongues are arranged the locking studs (26) intended for engagement in the recesses (34) of the modules (20).

11. Illumination kit according to one of claims 5 to 7, **characterised in that** it additionally comprises an in particular plate-like cover (35) that forms between itself and the contacts (31, 32) of the contact carrier (20) oppositely facing slit recesses for boundary edges of two modules (20) to be joined together.

12. Illumination kit according to claim 11, **characterised in that** the contact carrier (20) and cover (35) can lockably engage with one another.

## Revendications

1. Jeu de pièces d'éclairage pour l'éclairage, l'affichage ou la signalisation, comprenant au moins deux modules (10) dispensateurs de lumière, identiques, ayant chacun au moins une DEL (12) et les composants électroniques nécessaires à leur commande, tels que des pistes conductrices (14), des résistances (13) ou analogues, et ayant chacun un jeu de zones de contact (15/16) disposées près de la bordure sur le module (10), avec au moins deux zones de contact de potentiel différent pour le raccordement ou le prélèvement de la tension, **caractérisé en ce que** les zones de contact (15, 16) de chaque jeu de zones de contact (15/16) sont disposées suivant une ligne (17) orientée verticalement par rapport à l'arête de bordure voisine du module (10), et **en ce que**, pour assurer la liaison mécanique et électrique de deux modules (10) ensemble, est prévu une prise à enfichage (19) pouvant être enfichée sur le bord de chaque module (10), avec des contacts (31, 32) disposés globalement en une rangée (33), les contacts (31 ; 32), présentant chaque fois le même espacement vis-à-vis du plan médian transversal de la prise à enfichage (19), étant pontés.

2. Jeu de pièces d'éclairage selon la revendication 1, **caractérisé en ce que** les zones de contact (15, 16) sont mises en contact par la plaque à circuit imprimé (11) du module (10) et de manière que les contacts (31, 32) de la prise à enfichage (19) puissent contacter les zones de contact (15 ; 16) à volonté, depuis l'une ou l'autre face du module (10).

3. Jeu de pièces d'éclairage selon la revendication 1, **caractérisé en ce qu'**à chaque jeu de zones de contact (15/16) du module (10) est associé un évidement (34) pour l'engagement, de préférence redésolidarisable, d'un téton de verrouillage (26) de la prise à enfichage (19).

4. Jeu de pièces d'éclairage selon la revendication 3, **caractérisé en ce que** l'évidement (34) est disposé dans la même rangée (17) que les zones de contact (15, 16) du module (10), et le téton de verrouillage (26) est disposé dans la même rangée (33) que les contacts (31, 32) de la prise à enfichage (19).

5. Jeu de pièces d'éclairage selon l'une des revendications 1 à 4, **caractérisé en ce que** la prise à enfichage (19) comprend un support de contact (20) ainsi qu'un jeu de contact (31/32), dont les éléments de contact (21, 22) sont fixés, sur un côté du support de contact (20), sur celui-ci.

6. Jeu de pièces d'éclairage selon la revendication 5, **caractérisé en ce que** les éléments de contact (21, 22) sont de configuration plate et s'étendent sensiblement parallèlement au plan principal du support de contact (20) plat, se présentant sous forme de plaque.

7. Jeu de pièces d'éclairage selon la revendication 5 ou 6, **caractérisé en ce que** chaque élément de contact (21, 22) constitue un pont de contact pour la liaison des zones de contact (15 ; 16) du même potentiel de deux modules (20).

8. Jeu de pièces d'éclairage selon la revendication 7, **caractérisé en ce que** chaque élément de contact (21, 22) constitue un tronçon de fixation (28) et, lié à celui-ci par la matière, un tronçon de contact (29 ; 30), qui est chaque fois réalisé sensiblement en fourche, et **en ce que** les dents de fourche d'un élément de contact (22) sont disposées entre les dents de fourche d'un autre élément de contact (21), dans le même plan.

9. Jeu de pièces d'éclairage selon l'une des revendications 5 à 7, **caractérisé en ce que** les éléments de contact (21, 22) présentent des arêtes d'ancrage (27) pliées, à l'aide desquelles elles sont enfichées, par une liaison de forme et/ou de serrage, sur le téton d'encliquetage (24) du support de contact (20).

10. Jeu de pièces d'éclairage selon la revendication 2 ainsi que l'une des revendications 5 à 9, **caractérisé en ce que** sont réalisées des languettes élastiques (25) découpées de façon libre sur le support de contact (20), aux extrémités desquelles sont disposés les tétons de verrouillage (26) conçus pour l'engagement dans les évidements (34) des modules (20).

11. Jeu de pièces d'éclairage selon l'une des revendications 5 à 7, **caractérisé en ce qu'**il comprend en plus un couvercle (35), en particulier du genre d'une plaque, formant, entre lui et les contacts (31, 32) du support de contact (20), des logements en fente opposés les uns les autres pour les arêtes de bordure de deux modules (20) à relier.

12. Jeu de pièces d'éclairage selon la revendication 11, **caractérisé en ce que** le support de contact (20) et le couvercle (35) sont encliquetables ensemble.
